# FASCICULE DE BREVET EUROPEEN

(11) **EP 0 807 856 B1**
(45) Date de publication et mention de la délivrance du brevet: **28.01.2004**
(21) Numéro de dépôt: 97401068.8
(22) Date de dépôt: 14.05.1997
(51) Int. Cl.: G03F 9/00, G03F 7/20

(54) **Installation d'exposition à la lumière d'une plaque de circuit imprimé double face à travers des clichés**
Einrichtung zur doppelseitigen Belichtung eines gedruckten Schaltkreises mit Masken
Device for double-sided exposure of printed circuit boards using masks

(30) Priorité: 15.05.1996 FR 9606062
(43) Date de publication de la demande: 19.11.1997
(73) Titulaire: Automa-Tech, 27100 Val de Reuil (FR)
(72) Inventeur: Sorel, Alain, Garel, 27180 Les Baux St Croix (FR); Charbonnier, Serge, 27120 Chambray (FR)
(74) Mandataire: Dronne, Guy

(56) Documents cités:
- EP-A- 0 618 505
- US-A- 5 403 684

## Description

La présente invention a pour objet une installation d'exposition à la lumière d'une plaque de circuit imprimé double face à travers des clichés.

On sait que, parmi les opérations nécessaires à la réalisation d'une carte de circuit imprimé, il intervient une étape d'insolation, notamment pour la définition par photogravure de pistes conductrices. L'installation correspondante a pour fonction d'exposer aux ultraviolets pendant un temps donné les circuits imprimés recouverts d'un film ou d'une laque photosensible à travers un cliché pour insoler la partie correspondante de la laque ou du film photosensible définie par ce cliché.

On comprend bien sûr que, dans cette opération, un point fondamental consiste dans la précision du positionnement du cliché par rapport au circuit imprimé sur lequel on veut réaliser l'insolation.

L'énorme majorité des machines de ce type permet seulement l'exposition aux ultraviolets d'une seule face de la plaque de circuit imprimé. Cependant, lorsque la plaque du circuit imprimé est du type double face, ce qui est de plus en plus fréquent, l'utilisation de telles machines est peu adaptée puisqu'elle nécessite le passage de la plaque à deux reprises dans la machine d'exposition, ce qui nécessite donc notamment deux opérations de positionnement du cliché sur son support par rapport au circuit imprimé.

Pour remédier à cet inconvénient, on a déjà proposé des machines d'insolation permettant l'insolation simultanée à travers des clichés des deux faces du circuit imprimé. De telles machines sont décrites notamment dans le brevet américain 5,337,151 et dans la demande de brevet européen EP 618 505.

La machine décrite dans le brevet américain mentionné ci-dessus est basée sur le principe qui consiste à positionner par centrage mécanique le support inférieur et le support supérieur de cliché et à déplacer à l'aide d'une paire de doigts couplés entre eux le cliché par rapport à l'ensemble constitué par les supports inférieur et supérieur de clichés.

Cette machine présente de nombreux inconvénients, notamment du fait qu'il n'y a pas un positionnement réellement précis du cliché supérieur par rapport au cliché inférieur et du fait que le déplacement du circuit imprimé à l'aide de deux doigts couplés ne peut se faire dans les conditions de précision requises, en raison notamment des risques de flexion des doigts de déplacement du circuit imprimé.

En outre, cette machine ne permet pas le positionnement séparé du cliché supérieur par rapport à la face supérieure du circuit imprimé et le positionnement du cliché inférieur par rapport à la face inférieure du circuit imprimé. Or, une telle possibilité peut être utile dans certaines situations.

En ce qui concerne le brevet européen également mentionné ci-dessus, il correspond à une machine efficace dans la mesure où les déplacements du circuit imprimé par rapport aux clichés inférieur et supérieur se font à l'aide de deux doigts indépendantes qui permettent ainsi un bon positionnement du circuit imprimé. Par ailleurs, dans la machine décrite dans ce brevet, on a effectivement un positionnement réel du cliché supérieur par rapport au cliché inférieur. Cependant, cette machine ne permet pas un positionnement séparé du cliché supérieur par rapport à la face supérieure du circuit imprimé et un positionnement du cliché inférieur par rapport à la face inférieure du circuit imprimé. En outre, il existe également dans cette machine des risques d'erreur de positionnement en raison de la flexion des doigts servant au positionnement du circuit imprimé.

Pour remédier à ces inconvénients, un objet de la présente invention est de fournir une installation d'exposition à la lumière d'un circuit imprimé double face qui permette de pallier les inconvénients mentionnés ci-dessus et notamment, lorsque cela est nécessaire, de réaliser un positionnement séparé par rapport au circuit imprimé du support supérieur de cliché et du support inférieur de cliché.

Pour atteindre ce but, l'installation d'exposition est formée selon la revendication 1.

On comprend que, grâce aux dispositions spécifiques de l'installation d'exposition, le circuit imprimé est maintenu fixe par rapport au bâti de la machine, ce qui évite tout risque de positionnement imprécis du fait d'une flexion des moyens de déplacement du circuit imprimé puisque ces doigts sont fixes et, d'autre part, des moyens permettent de déplacer indépendamment le premier support par rapport au circuit imprimé et le deuxième support par rapport au circuit imprimé, ce qui permet d'obtenir donc des positionnements indépendants des clichés supérieur et inférieur par rapport au circuit imprimé.

Selon un premier mode de mise en oeuvre, les moyens pour maintenir fixe le circuit imprimé comprennent des premiers, deuxièmes et troisièmes moyens formant doigt de centrage solidaires dans un plan horizontal du bâti inférieur et traversant librement ledit support inférieur et présentant chacun une extrémité apte à pénétrer dans un orifice correspondant de repérage ménagé dans ledit circuit, lesdits trois orifices n'étant pas alignés.

On comprend que, selon ce mode de mise en oeuvre de l'invention, les doigts de centrage qui sont fixes et solidaires du bâti inférieur permettent un positionnement très précis et stable du circuit imprimé par rapport au bâti de la machine et donc par rapport aux clichés supérieur et inférieur.

Selon un deuxième mode de mise en oeuvre, les moyens pour maintenir fixe le circuit imprimé comprennent un premier et un deuxième ensemble de pincement, chaque ensemble de pincement comprenant

un premier organe de pincement solidaire du premier bâti et traversant librement le premier support et un deuxième organe de pincement solidaire du deuxième bâti et traversant librement le deuxième support, lesdits organes de pincement se faisant face selon la direction verticale, et des moyens pour déplacer relativement les premier et deuxième organes de pincement l'un vers l'autre pour pincer le circuit imprimé.

On comprend que, dans ce mode de réalisation, le circuit imprimé est pincé entre deux organes de pincement respectivement solidaires du bâti supérieur et inférieur. On obtient ainsi un positionnement très précis et stable du circuit imprimé par rapport au bâti de l'installation d'insolation. A partir de cette position précise du circuit imprimé, il est possible, à l'aide des moyens de déplacement, de positionner séparément le support de cliché supérieur et le support de cliché inférieur.

D'autres caractéristiques et avantages de l'invention apparaîtront mieux à la lecture de la description qui suit de plusieurs modes de réalisation de l'invention donnés à titre d'exemple non limitatif.

La description se réfère aux figures annexées sur lesquelles :
- la figure 1a est une vue schématique de dessus de la partie inférieure de l'installation d'exposition montrant les principaux organes de cette partie inférieure;
- la figure 1b est une vue simplifiée en coupe verticale de l'installation;
- la figure 2 est une vue partielle de l'installation montrant un dispositif de pincement pour immobiliser le circuit imprimé;
- la figure 3 est une vue de détail de l'installation montrant les moyens d'immobilisation du circuit imprimé à l'aide de doigts;
- la figure 4 est une vue de détail montrant l'extrémité des doigts d'immobilisation de la figure 3;
- la figure 5 est une en élévation de moyens de solidarisation des supports de cliché par rapport au bâti;
- la figure 6 est une vue de détail montrant des moyens de supportage du support de cliché par le bâti; et
- la figure 7 est une vue de détail montrant un mode de réalisation des moteurs de déplacement du support inférieur ou du support supérieur de cliché par rapport aux bâtis fixes.

Dans ce type d'installation, il est bien connu que, dans un premier temps, on réalise un pré-positionnement du circuit imprimé par rapport au support de cliché à l'aide de doigts escamotables de positionnement. A partie de ce pré-positionnement du circuit imprimé par rapport au support de cliché supérieur et inférieur, on effectue par des moyens optiques une mesure de l'erreur de positionnement de ces trois parties. A partir de ces mesures d'erreur de positionnement, on commande des moteurs de déplacement pour réaliser le positionnement final qui doit correspondre à une erreur de positionnement inférieure à 10 microns. La présente invention concerne la partie de l'installation permettant d'obtenir le positionnement final à partir de la mesure de l'erreur correspondant au pré-positionnement.

La détection optique de l'erreur de positionnement a été décrite en détail dans la demande de brevet européen 618 505. Pour cette partie de l'installation, il est donc fait référence à la description de cette demande de brevet. On précisera simplement dans certains modes de mise en oeuvre des variantes de réalisation et d'utilisation du système optique de détection de l'erreur de pré-positionnement.

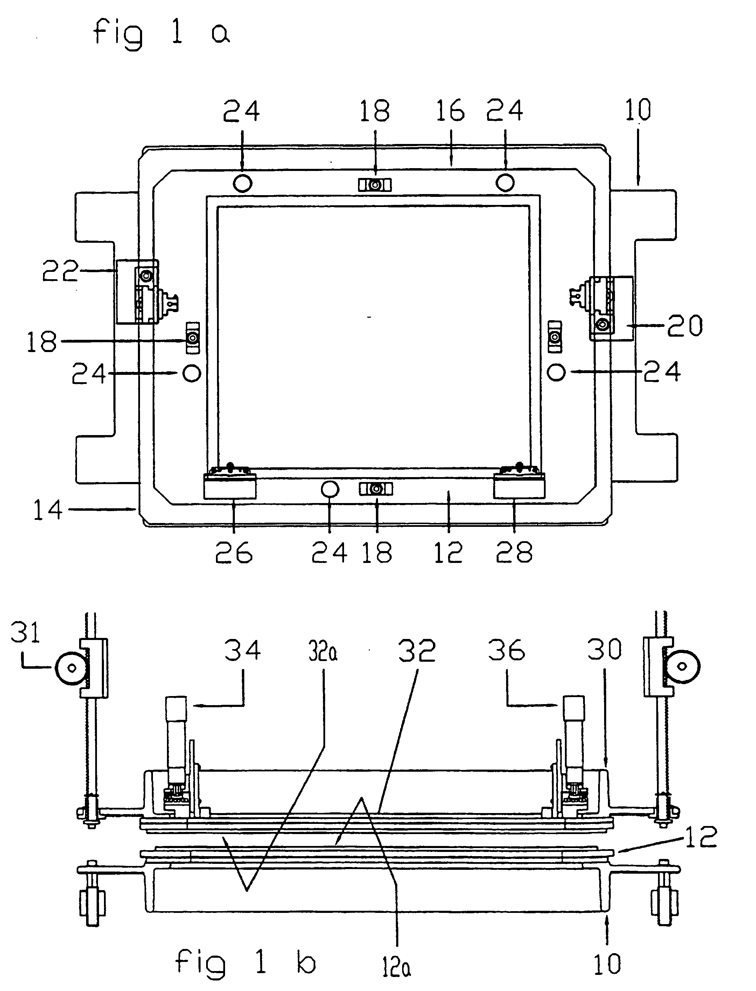

En se référant tout d'abord aux figures 1a et 1b, on va décrire les différentes parties de l'installation et, plus précisément, la partie inférieure de cette installation destinée à supporter le cliché inférieur et, d'une certaine manière, le circuit imprimé.

Sur la figure 1, on a fait apparaître le bâti inférieur fixe de la machine référencé 10, ainsi que le support inférieur de cliché 12. Ce support inférieur 12 est constitué par un cadre métallique rectangulaire 14 sur lequel est fixée une glace 16, glace sur laquelle repose effectivement le cliché inférieur.

De préférence, dans l'installation d'exposition, le support inférieur de cliché 12 repose directement sur la face supérieure du bâti 10. Pour permettre les déplacements du support 12, celui-ci repose sur le bâti 10 par l'intermédiaire de systèmes à billes schématisés en 18. Dans l'exemple particulier, le supportage se fait par l'intermédiaire de quatre billes disposées sur les quatre côtés du cadre 14. Ce système à billes qui sera décrit ultérieurement plus en détail permet de faire supporter mécaniquement l'ensemble du support inférieur par le bâti tout en assurant un supportage avec un frottement extrêmement réduit. On comprend que, grâce à cette disposition, l'effort qu'il faudra appliquer pour déplacer le support inférieur 14 sera donc très réduit, ce qui permettra de réduire en conséquence la puissance et donc la taille des moteurs servant à réaliser ce déplacement.

Sur cette figure, on a également représenté schématiquement les dispositifs 20 et 22 de déplacement respectivement en X et en XY du support inférieur 12. Comme on l'a déjà expliqué, les tables de déplacement qui sont solidaires du bâti 10 ne réalisent aucune fonction de supportage et servent simplement à déplacer le support par rapport au bâti, étant ajouté que les frottements entre ces deux pièces étant très réduits et grâce à la présence des billes, l'énergie nécessaire est réduite. Sur la figure la, on a également représenté de façon schématique des freins électromagnétiques ou autre système de freinage similaire en 24. Ces systèmes de freinage 24 régulièrement répartis sur le cadre 14 permettent d'assurer l'immobilisation du cadre 14 et donc de l'ensemble du support inférieur de cliché 12 par rapport au bâti 10 lorsqu'un positionnement correct a été obtenu. Ces dispositifs de freinage 24 sont rendus nécessaires du fait de la liaison sans frottement entre le bâti et le support inférieur et du fait de la très faible puissance des moteurs utilisés pour réaliser les tables de déplacement 20 et 22.

Enfin, sur la figure 1a, on a représenté schématiquement deux ensembles d'immobilisation du circuit imprimé par rapport au bâti inférieur 10. Ces ensembles sont référencés 26 et 28.

La partie supérieure de la machine est constituée exactement de la même manière à l'exception du fait que le bâti inférieur 10 est immobile, aussi bien dans un plan horizontal que dans un plan vertical, alors que, bien entendu, le bâti supérieur est immobile dans un plan horizontal mais mobile dans un plan vertical pour permettre l'application du cliché supérieur sur le circuit imprimé et sur le cliché inférieur. On ne décrira donc pas en détail la partie supérieure de la machine.

La figure 1b montre en coupe verticale et de façon schématique l'ensemble de l'installation d'exposition. On retrouve le bâti inférieur fixe 10 sur lequel repose le support inférieur 12 destiné à recevoir le cliché inférieur 12a. Sur cette figure, on a également représenté le bâti supérieur 30 qui est supporté par l'intermédiaire de mécanismes 32 tels que des systèmes pignon crémaillère permettant de faire monter et descendre l'ensemble du bâti supérieur 30. Par ailleurs, ce bâti 30 est bien sûr fixe dans un plan horizontal. Sur le bâti supérieur 30, est monté le support supérieur 32 identique au support inférieur 12, destiné à recevoir le cliché supérieur 32a. Sur la figure 1b, on a représenté schématiquement les moteurs de déplacement en X et XY référencés 34 et 36 qui permettent de commander le déplacement du support 32 par rapport au bâti supérieur 30.

On comprend dès à présent le fonctionnement général de l'installation d'exposition selon l'invention:

Dans un premier temps, le bâti supérieur 30 étant écarté et les clichés 12a et 32a étant mis en place, on vient disposer entre les supports 12 et 32 le circuit imprimé à exposer. Le circuit imprimé à exposer est saisi à l'aide des dispositifs d'immobilisation 26 et 28. A l'aide des systèmes optiques non représentés, on mesure les erreurs de prépositionnement du support inférieur 12 et du support supérieur 32 par rapport au circuit imprimé. Le circuit imprimé restant immobile, on commande à l'aide des moteurs 20, 22 et 34, 36 les déplacements convenables du support supérieur 32 et du support inférieur 12 afin d'obtenir un alignement des trois éléments ou, selon les cas, un alignement du support supérieur 32 avec la face supérieure du circuit imprimé et du support inférieur 12 avec la face inférieure du circuit imprimé.

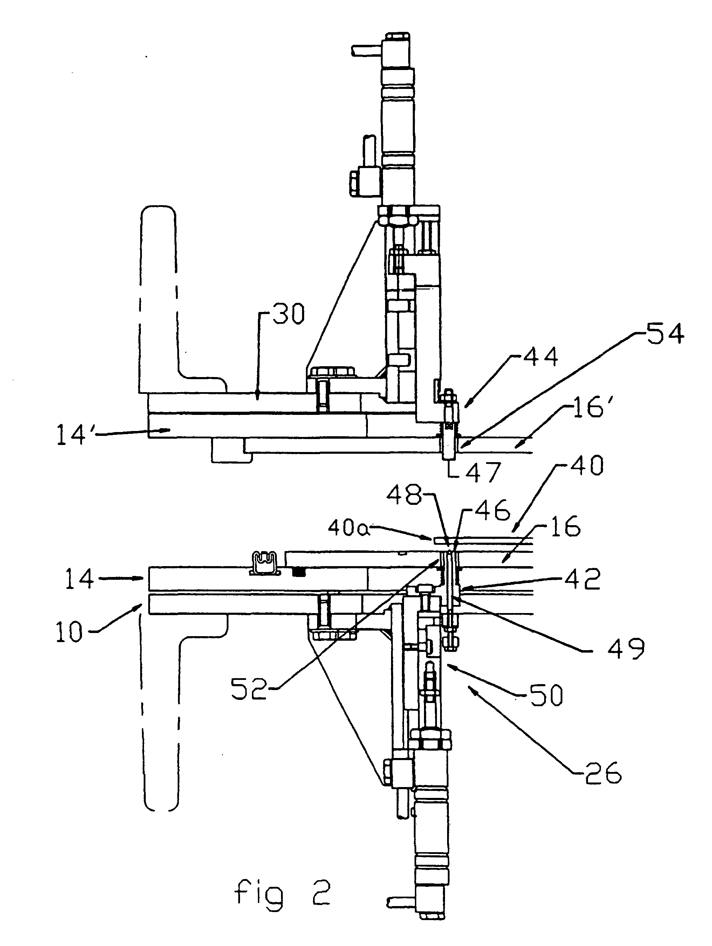

En se référant maintenant à la figure 2, on va décrire un premier mode de réalisation du dispositif d'immobilisation, par exemple, le dispositif 26. Dans ce premier mode de réalisation, l'immobilisation est réalisée par pincement ponctuel d'un bord 40a du circuit imprimé 40. Le dispositif pincement est constitué essentiellement par une première pièce 42 qui est solidaire du bâti inférieur 10 et par une deuxième pièce 44 qui est solidaire du bâti supérieur 30. Les pièces 42 et 44 sont mobiles verticalement par rapport respectivement aux bâtis 10 et 30. Les pièces 42 et 44 se terminent par une face plane de pincement 46 et 47 destinée à être appliquée sur les faces du circuit imprimé 40. La pièce inférieure 42 est munie d'une tige 49 mobile en translation verticale, qui se termine par une pointe 48. En position de repos, la pointe 48 est en retrait par rapport à la face 46, mais, à l'aide d'un système de déplacement 50, la pointe 48 peut faire saillie hors de la face 46.

Lors de la phase de positionnement des supports supérieur et inférieur de l'installation d'exposition, la pointe 48 fait saillie hors de la pièce 42. Après mise en place du circuit imprimé 40 par référence à des repères pré-définis, la pièce 44 est abaissée de telle manière que le bord 40a du circuit imprimé 40 soit pris entre la face 47 de la pièce 44 et la pointe 48. Ainsi, le circuit imprimé est parfaitement immobilisé en ce point et sur une surface très réduite correspondant à la pointe 48. En outre, la pointe 48 faisant saillie hors de la surface 46 qui est de niveau avec la face supérieure de la glace 16, le circuit imprimé est soulevé au moins à sa périphérie, ce qui permet le déplacement de la glace 16 par rapport au circuit imprimé. Bien entendu, pour permettre le pincement effectif du circuit imprimé 40, les extrémités des pièces 42 et 44 traversent des orifices 52 et 54 respectivement ménagés dans les glaces inférieure 16 et supérieure 16'. Ces orifices 52 et 54 ont un diamètre suffisant pour permettre le déplacement des supports 14 et 14' afin de réaliser l'alignement. La coopération des deux dispositifs d'immobilisation 26 et 28 permet de maintenir rigoureusement en place le circuit imprimé 40 par rapport au bâti de l'installation.

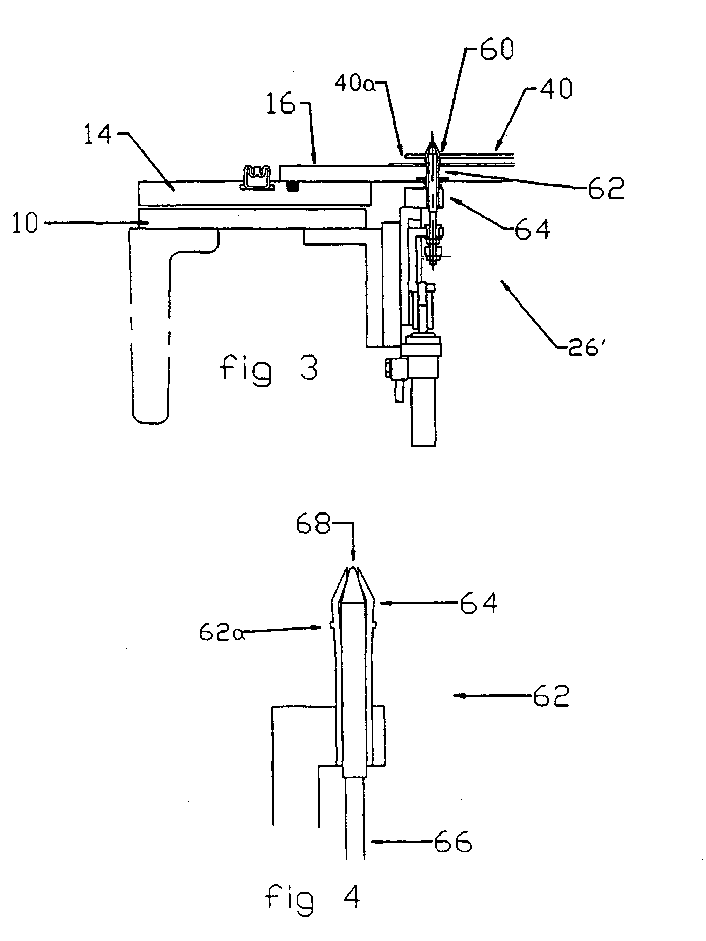

En se référant maintenant aux figures 3 et 4, on va décrire un deuxième mode de réalisation du dispositif d'immobilisation qui porte alors la référence 26'. Ce dispositif d'immobilisation est basé sur l'introduction dans un orifice 60 du circuit imprimé 40 d'un doigt d'immobilisation 62. Le doigt 62 est monté déplaçable selon la direction verticale par rapport à une pièce 64 solidaire du bâti inférieur 10. Le doigt d'immobilisation 62 est donc mobile verticalement mais immobile dans un plan horizontal. Par pénétration de l'extrémité du doigt 62 dans l'orifice 60, on obtient donc une immobilisation de cette partie correspondante du circuit imprimé 40 par rapport au bâti inférieur. Pour obtenir l'immobilisation complète du circuit imprimé, il est nécessaire de prévoir le long du bord 40a du circuit imprimé trois dispositifs d'immobilisation tels que 26', ces trois dispositifs n'étant pas alignés.

La figure 4 montre un mode préféré de réalisation du doigt 62 d'immobilisation. Le corps du doigt 62 se prolonge par une partie expansible 64 par déformation, l'ensemble des parties expansibles 64 formant la pointe du doigt d'immobilisation. En outre, l'épaulement 62a permet le soulèvement temporaire du bord du circuit imprimé afin de permettre le déplacement du support inférieur. A l'intérieur du doigt 62, on peut déplacer une tige d'expansion 66 qui se termine par une tête 68. Lorsque la tête 68 est en position haute, on réalise l'expansion des parties terminales 64 du doigt et donc une immobilisation rigoureuse de cette partie du circuit imprimé, même si l'orifice 60 d'immobilisation n'est pas parfaitement calibré.

On comprend que les modes de réalisation des moyens d'immobilisation des figures 2 et 3 permettent d'obtenir le même résultat. Cependant, dans le cas de la figure 2, du fait qu'il n'est pas nécessaire de prévoir un orifice à proximité du bord du circuit imprimé, la zone latérale non utile du circuit imprimé peut être réduite à une dimension de l'ordre de 8 mm. En revanche, dans le cas du mode de réalisation de la figure 3, en raison de la présence de l'orifice, cette zone latérale non utile est nécessairement un peu plus importante.

Il faut ajouter que, grâce à ces systèmes d'immobilisation du circuit imprimé, le positionnement du circuit imprimé est maintenu de façon rigoureuse durant les phases de déplacement du support inférieur 12. En effet, aussi bien les doigts d'immobilisation 62 que les pièces de pincement 42 et 44 étant elles-mêmes immobiles, aucune contrainte de flexion ne peut leur être induite.

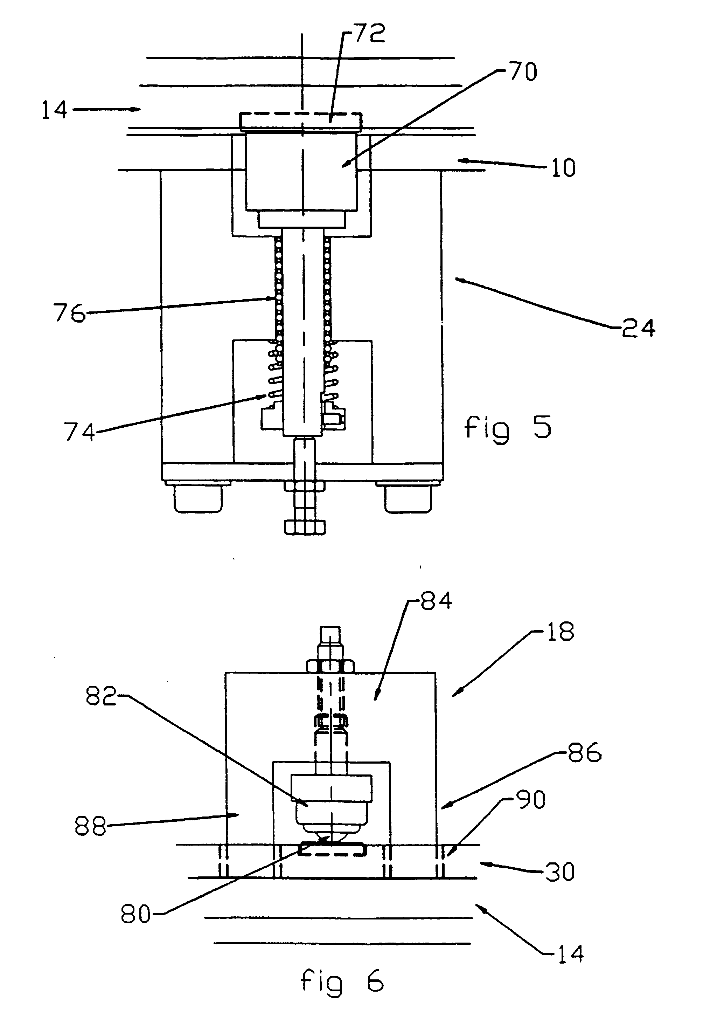

En se référant maintenant à la figure 5, on va décrire un exemple de réalisation du dispositif 24 de solidarisation du bâti inférieur 10 avec le cadre 14 du support inférieur 12. Des dispositifs identiques seraient utilisables pour réaliser la solidarisation du support supérieur 32 avec le bâti supérieur 30. Le système d'immobilisation est essentiellement constitué par une tête électromagnétique 70 qui, lorsqu'elle est activée, coopère avec une plaquette ferromagnétique 72 solidaire de la face inférieure du cadre 14 du support inférieur 12. En activant la tête magnétique 70, on obtient une solidarisation entre le bâti inférieur 10 et le support inférieur 12. La tête électromagnétique 70 est montée par l'intermédiaire d'un système élastique 74 et d'un système à billes 76. Ces dispositifs de solidarisation permettent de maintenir le positionnement rigoureux des supports supérieur et inférieur lors de l'abaissement du support supérieur pour réaliser un contact entre les deux clichés et les faces du circuit imprimé 40.

Les dispositifs électromagnétiques qui viennent d'être décrits constituent des moyens avantageux de solidarisation. Cependant, pour obtenir la solidarisation du support sur le bâti, on pourrait également utiliser des systèmes à pression ou encore des systèmes à aspiration.

En se référant maintenant à la figure 6, on va décrire un mode de réalisation des billes de supportage 18 permettant le supportage ou la sustentation du support par rapport aux bâtis respectivement inférieur et supérieur. La figure 6 illustre un dispositif de sustentation 18 reliant le cadre 14' du support supérieur 12' au bâti supérieur 30. Le dispositif à billes est essentiellement constitué par une bille métallique 80 montée rotulante dans une cage 82. La cage 82 est reliée par un système d'étrier 84 au cadre 14' du support supérieur. Pour cela, les bras 86 et 88 de l'étrier traversent le bâti 30 par des trous tels que 90. Pour assurer un meilleur roulement et donc diminuer encore le frottement, la bille 80 coopère avec une surface de roulement 92 solidaire de la face supérieure du bâti 30.

Dans le cas du supportage du cadre du support inférieur par le bâti, on a le même système à billes mais dont l'axe est inversé de telle manière que la cage 82 de la bille 80 soit solidaire du bâti inférieur 10 et que la bille coopère avec la face inférieure du cadre 14 du support inférieur 12. Le supportage du cadre du support de cliché pourrait également être réalisé par des dispositifs par coussin d'air.

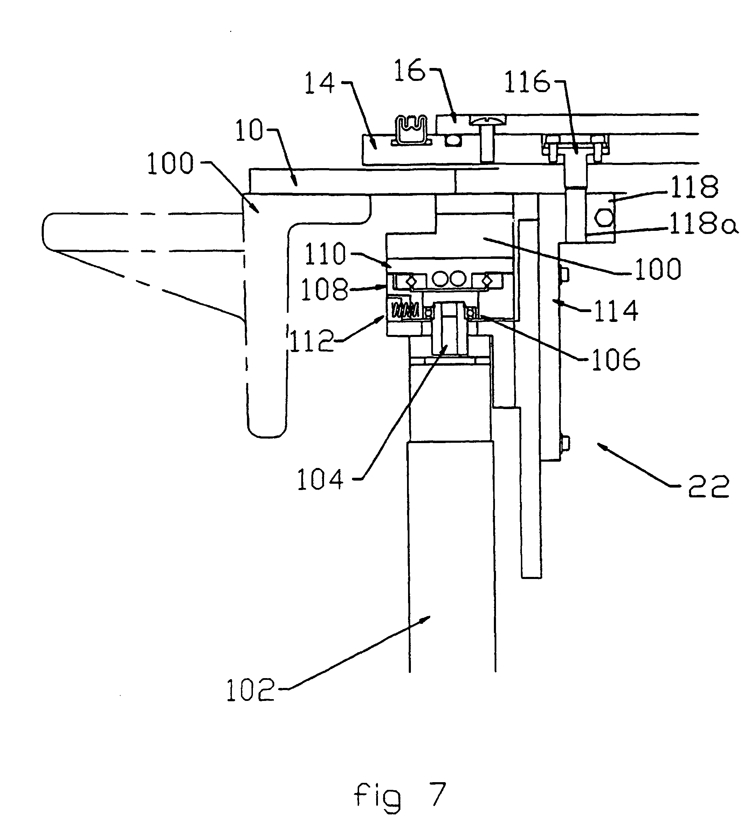

En se référant maintenant à la figure 7, on va décrire un mode préféré de réalisation des dispositifs de déplacement 20 et 22 ou 34 et 36 permettant le positionnement final de chaque support par rapport au bâti correspondant. Sur la figure 7, on a par exemple représenté le dispositif de déplacement 22 permettant un déplacement en X et en Y du support inférieur 12. Des systèmes de déplacement similaires sont utilisés en liaison avec le bâti supérieur 30. Le système de déplacement 32 présente un carter 100 qui est solidaire du bâti 10. Pour chaque déplacement en X ou en Y, on trouve un moteur, par exemple 102 solidaire du bâti 100. Ce moteur a son arbre 104 qui se termine par une came 106 permettant de déplacer une première table 108 selon la direction X. Une deuxième table 110 coopérant avec la première et associée à un deuxième moteur, solidaire de la première table et non représenté sur la figure, contrôle le déplacement selon la direction Y. Par un renvoi mécanique 112, 114, le déplacement combiné en X et Y est appliqué à la pièce 18 qui définit un alésage vertical calibré 118a. Un ergot vertical 116 solidaire du cadre 14 pénètre librement dans l'alésage 118a selon la direction verticale mais dans le plan horizontal, le jeu entre les pièces est très réduit mais sans serrage. On pourrait également prévoir que l'ergot soit solidaire de la deuxième table et que l'alésage vertical soit réalisé dans le cadre 14 du support.

## Revendications

1. Installation d'exposition à la lumière d'une plaque de circuit imprimé double face à travers un premier et un deuxième cliché muni d'une marque de repérage comprenant
un premier et un deuxième bâti (10, 30) fixe dans un plan horizontal,
un premier et un deuxième support (12, 32) des premier et deuxième clichés coopérant respectivement avec les premier et deuxième bâtis, chaque support comprenant un cadre (14) et une glace (16) solidaire du cadre et recevant ledit cliché ;
des moyens pour disposer ledit circuit entre les premier et deuxième supports de cliché, ledit circuit étant muni d'un marquage de repérage en position,
des moyens optiques pour détecter les erreurs de position entre ledit circuit et lesdits premier et deuxième supports,
des moyens (31) pour déplacer perpendiculairement à leurs plans un desdits support vers l'autre support,
une source lumineuse, et
des moyens optiques pour diriger simultanément vers chaque support de cliché un faisceau lumineux à partie du faisceau émis par ladite source,
ladite installation **se caractérisant en ce qu'**elle comprend en outre :
des moyens (26, 28) disposés à l'extérieur de l'ensemble constitué par lesdits supports et ledit circuit pour maintenir fixe dans son plan ledit circuit par rapport audit bâti; et
des moyens (20, 22, 34, 36) pour déplacer indépendamment ledit premier support par rapport audit circuit et ledit deuxième support par rapport audit circuit en fonction des erreurs de position détectées.

2. Installation selon la revendication 1, **caractérisée en ce que** les moyens pour maintenir fixe ledit circuit imprimé comprennent:
des premiers, deuxièmes et troisièmes moyens formant doigt de centrage (62) solidaires dans un plan horizontal du bâti inférieur (10) et traversant librement ledit support inférieur (12) et présentant chacun une extrémité apte à pénétrer dans un orifice (60) correspondant de repérage ménagé dans ledit circuit, lesdits trois orifices n'étant pas alignés.

3. Installation selon la revendication 2, **caractérisée en ce que** l'extrémité de chaque moyen formant doigt (62) est expansible (64, 66, 68).

4. Installation selon la revendication 1, **caractérisée en ce que** les moyens pour maintenir fixe ledit circuit imprimé comprennent:
un premier (26) et un deuxième (28) ensemble de pincement, chaque ensemble de pincement comprenant
un premier organe de pincement (42) solidaire du premier bâti et traversant librement le premier support (52, 54) et un deuxième organe de pincement (44) solidaire du deuxième bâti et traversant librement le deuxième support, lesdits organes de pincement se faisant face selon la direction verticale, et des moyens pour déplacer relativement les premier et deuxième organes de pincement l'un vers l'autre pour pincer le circuit imprimé.

5. Installation selon la revendication 4, **caractérisée en ce que** chaque organe de pincement présente une extrémité définissant une surface plane horizontale de pincement (46, 47) et **en ce que** l'organe inférieur de pincement d'un ensemble de pincement comprend en outre une tige (49) montée coulissante verticalement dans ledit organe et présentant une extrémité pointue (48) apte à faire saillie dans la surface de pincement et des moyens pour commander le déplacement de ladite pointe par rapport audit organe de pincement.

6. Installation selon l'une quelconque des revendications 1 à 5, **caractérisée en ce que** les moyens de déplacement comprennent deux moyens moteurs (20, 22) solidaires du premier bâti pour déplacer le premier support par rapport au premier bâti et deux moyens moteurs (34, 36) solidaires du deuxième bâti pour déplacer le deuxième support par rapport au deuxième bâti.

7. Installation selon la revendication 6, **caractérisée en ce que** les moyens de déplacement comprennent en outre des moyens de supportage sans frottement (18) du rapport inférieur par rapport au bâti inférieur et des moyens de sustentation sans frottement (18) du support supérieur par rapport au bâti supérieur.

8. Installation selon la revendication 7, **caractérisée en ce que** les moyens de déplacement comprennent en outre des moyens commandables (24) pour solidariser indépendamment dans un plan horizontal le support inférieur par rapport au bâti inférieur et le support supérieur par rapport au bâti supérieur.

9. Installation selon l'une quelconque des revendications 7 et 8, **caractérisée en ce que** lesdits supports de clichés comprennent une glace et un cadre métallique et **en ce que** lesdits moyens de supportage comprennent une pluralité de billes interposées entre le bâti inférieur et ledit cadre, et **en ce que** les moyens de sustentation comprennent une pluralité de billes interposées entre le bâti supérieur et des étriers solidaires du cadre du support supérieur.

10. Installation selon l'une quelconque des revendications 7 à 9, **caractérisée en ce que** lesdits moyens de solidarisation comprennent des moyens de freinage électromagnétiques solidaires des bâtis aptes à coopérer avec des éléments ferromagnétiques solidaires desdits cadres.

11. Installation selon l'une quelconque des revendications 6 à 10, **caractérisée en ce que** chaque moyen moteur comprend en sortie d'arbre une came coopérant positivement avec un ergot engagé dans un orifice du support à déplacer.

## Claims

1. An installation of light exposure of a double-sided printed circuit plate through a first and a second artwork equipped with a location mark including
a first and a second fixed supporting structure (10, 30) in a horizontal plane,
a first and a second support (12, 32) of the first and second artworks co-operating with the first and second supporting structures respectively, each support comprising a frame (14) and a glass (16) integral with the frame and receiving said artwork,
means for arranging said circuit between the first and second artwork supports, said circuit being equipped with a position location mark,
optical means for detecting the positioning errors between said circuit and said first and second supports,
means (31) for moving perpendicularly to its plane, one of said supports towards the other support,
a light source,
optical means for simultaneously directing towards each artwork support a light beam from the beam emitted by said source,
said installation being **characterised in that** it further comprises:
means (26, 28) arranged outside the unit made up of said supports and said circuit to maintain said circuit fixed in its plane with respect to said supporting structure; and
means (20, 22, 34, 36) for moving independently said first support with respect to said circuit and said second support with respect to said circuit depending on the detected positioning errors.

2. An installation according to claim 1, **characterised in that** the means for maintaining fixed said printed circuit include:
first, second and third means forming a centring finger (62) that are integral with the lower supporting structure (10) in a horizontal plane and going freely through said lower support (12) and each having an end that is capable of entering a corresponding location orifice (60) provided in said circuit, said three orifices not being aligned.

3. An installation according to claim 2, **characterised in that** the end of each finger-forming means (62) is expansible (64, 66, 68).

4. An installation according to claim 1, **characterised in that** the means for maintaining said printed circuit fixed include:
a first and a second pinching unit (26, 28), each pinching unit including
a first pinching member (42) integral with the first supporting structure and going freely through the first support (52, 54) and a second pinching member (44) integral with the second supporting structure and going freely through the second support, said pinching members facing one another in the vertical direction and means for relatively moving the first and second pinching members towards each other so as to pinch the printed circuit.

5. An installation according to claim 4, **characterised in that** each pinching member has an end defining a flat horizontal pinching surface (46, 47) and **in that** the lower pinching member of a pinching unit further includes a rod (49) mounted so as to slide vertically in said member and having a sharp end (48) suitable for projecting in the pinching surface and means for controlling the displacement of said tip with respect to said pinching member.

6. An installation according to any one of claims 1 to 5, **characterised in that** the displacement means include two motor means (20, 22) integral with the first supporting structure to move the first support with respect to the first supporting structure and two motor means (34, 36) integral with the second supporting structure to move the second support with respect to the second supporting structure.

7. An installation according to claim 6, **characterised in that** the displacement means further include supporting means without friction (18) of the lower support with respect to the lower supporting structure and lifting means without friction (18) of the upper support with respect to the upper supporting structure.

8. An installation according to claim 7, **characterised in that** the displacement means further include controllable means (24) for securing independently in a horizontal plane the lower support with respect to the lower supporting structure to the upper support with respect to the upper supporting structure.

9. An installation according to claim 7 or 8, **characterised in that** said artwork supports include a glass and a metal frame and **in that** said supporting means include a plurality of balls that are interposed between the lower supporting structure and said frame, and **in that** the lifting means include a plurality of balls interposed between the upper supporting structure and clamps integral with the frame of the upper support.

10. An installation according to any one of claims 7 to 9, **characterised in that** said fastening means include electromagnetic braking means integral with the supporting structures suitable for co-operating with ferromagnetic elements integral with said frames.

11. An installation according to any one of claims 6 to 10, **characterised in that** each motor means includes at the end of the shaft a cam that co-operates positively with a pin engaged through an orifice of the support to move.

## Patentansprüche

1. Einrichtung zur doppelseitigen Belichtung einer Platte eines gedruckten Schaltkreises durch eine erste und eine zweite Maske, die mit einer Marke ausgestattet ist, wobei die Einrichtung
ein erstes und ein zweites Gestell (10, 30), das fest in einer horizontalen Ebene ist,
einen ersten und einen zweiten Träger (12, 32) der ersten und zweiten Maske, der jeweils mit dem ersten und zweiten Gestell zusammenwirkt, wobei jeder Träger einen Rahmen (14) und eine Scheibe (16) aufweist, die mit dem Rahmen verbunden ist und die Maske aufnimmt;
Mittel um den Schaltkreis zwischen dem ersten und zweiten Maskenträger anzuordnen, wobei der Schaltkreis mit einer Markierung in Position ausgestattet ist,
optische Mittel, um Fehler in der Position zwischen dem Schaltkreis und dem ersten und zweiten Träger aufzuspüren,
Mittel (31), um einen der Träger senkrecht zu seiner Ebene zum anderen Träger zu verschieben,
eine Lichtquelle, und
optische Mittel, um gleichzeitig zu jedem Maskenträger ein Lichtbündel als Teil des von der Quelle emittierten Strahls zu lenken,
aufweist,
wobei die Einrichtung **dadurch kennzeichnet ist, dass** sie außerdem aufweist:
Mittel (26, 28), die außerhalb der Anordnung eingerichtet sind, die gebildet ist durch die Träger und den Schaltkreis, um den Schaltkreis bezüglich dem Gestell fest in seiner Ebene zu halten; und
Mittel (20, 22, 34, 36), um unabhängig den ersten Träger bezüglich des Schaltkreises und den zweiten Träger bezüglich des Schaltkreises in Abhängigkeit der entdeckten Positionsfehler zu verschieben.

2. Einrichtung nach Anspruch 1, **dadurch gekennzeichnet, dass** die Mittel, um den gedruckten Schaltkreis fest zu halten, aufweisen:
einen Zentrierungsfinger (62) bildende erste, zweite und dritte Mittel aufweisen, die in einer horizontalen Ebene mit dem unteren Gestell (10) verbunden sind und den unteren Träger (12) frei passieren und jeweils ein Ende aufweisen, das in eine entsprechende Markierungsöffnung (60) eintreten kann, die in dem Schaltkreis angebracht ist, wobei die drei Öffnungen nicht gerade ausgerichtet sind.

3. Einrichtung nach Anspruch 2, **dadurch gekennzeichnet, dass** das Ende jedes einen Finger (62) bildenden Mittels verlängerbar (64, 66, 68) ist.

4. Einrichtung nach Anspruch 1, **dadurch gekennzeichnet, dass** die Mittel, um den gedruckten Schaltkreis fest zu halten, aufweisen:
eine erste (26) und eine zweite (28) Klemmanordnung, wobei jede Klemmanordnung
ein erstes Klemmelement (42), das mit dem ersten Gestell verbunden ist und den ersten Träger (52, 54) frei durchquert, und ein zweites Klemmelement (44), das mit dem zweiten Gestell verbunden ist und den zweiten Träger frei durchquert, wobei die Klemmelemente sich in vertikaler Richtung gegenüberstehen und Mittel zum jeweiligen gegenseitigen Verschieben des ersten und zweiten Klemmelements, um den gedruckten Schaltkreis einzuklemmen, aufweist.

5. Einrichtung nach Anspruch 4, **dadurch gekennzeichnet, dass** jedes Klemmelement ein Ende aufweist, das eine horizontale, ebene Klemmfläche (46, 47) aufweist und dass das untere Klemmelement einer Klemmanordnung außerdem eine Stange (49) zeigt, die vertikal gleitend in dem Element befestigt ist und ein spitzes Ende (48) aufweist, das in die Klemmfläche vorragen kann und Mittel zur Steuerung der Verschiebung der Spitze bezüglich dem Klemmelement aufweist.

6. Einrichtung nach einem der Ansprüche 1 bis 5, **dadurch gekennzeichnet, dass** die Verschiebungsmittel zwei Motormittel (20, 22), die mit dem ersten Gestell verbunden sind, um den ersten Träger bezüglich dem ersten Gestell zu verschieben und zwei Motormittel (34, 36) aufweisen, die mit dem zweiten Gestell verbunden sind, um den zweiten Träger bezüglich dem zweiten Gestell zu verschieben.

7. Einrichtung nach Anspruch 6, **dadurch gekennzeichnet, dass** die Mittel zum Verschieben außerdem Mittel zur Abstützung ohne Reibung (18) der unteren Verbindung bezüglich dem unteren Gestell und Mittel zum Unterstützen ohne Reibung (18) des oberen Trägers bezüglich dem oberen Gestell aufweisen.

8. Einrichtung nach Anspruch 7, **dadurch gekennzeichnet, dass** die Mittel zum Verschieben außerdem steuerbare Mittel (24) aufweisen, um unabhängig in einer horizontalen Ebene den unteren Träger bezüglich dem unteren Gestell und den oberen Träger bezüglich dem oberen Gestell zu verbinden.

9. Einrichtung nach einem der Ansprüche 7 und 8, **dadurch gekennzeichnet, dass** die Maskenträger eine Scheibe und einen metallischen Rahmen aufweisen, und dass die Mittel zur Abstützung eine Mehrzahl von Kugeln aufweisen, die zwischen dem unteren Gestell und dem Rahmen liegen und dass die Mittel zum Unterstützen eine Mehrzahl von Kugeln aufweisen, die zwischen dem oberen Gestell und Bügeln liegen, die mit dem Rahmen des oberen Trägers verbunden sind.

10. Einrichtung nach einem der Ansprüche 7 bis 9, **dadurch gekennzeichnet, dass** die Verbindungsmittel Mittel zum elektromagnetischen Bremsen aufweisen, die mit Gestellen verbunden sind, die mit mit den Rahmen verbundenen ferromagnetischen Elementen zusammenwirken können.

11. Einrichtung nach einem der Ansprüche 6 bis 10, **dadurch gekennzeichnet, dass** jedes Motormittel am Ausgang der Welle eine Nocke aufweist, die positiv mit einem Zapfen zusammenwirkt, der in eine Öffnung des zu bewegenden Trägers eingreift.
